(19) Europäisches Patentamt
European Patent Office
Office européen des brevets

(11) **EP 2 668 716 B1**

(12) **FASCICULE DE BREVET EUROPEEN**

(45) Date de publication et mention de la délivrance du brevet:
**03.12.2014 Bulletin 2014/49**

(21) Numéro de dépôt: **12700493.5**

(22) Date de dépôt: **19.01.2012**

(51) Int Cl.:
*H02N 2/18* *(2006.01)*

(86) Numéro de dépôt international:
**PCT/EP2012/050804**

(87) Numéro de publication internationale:
**WO 2012/101037 (02.08.2012 Gazette 2012/31)**

(54) **CIRCUIT D'OPTIMISATION DE LA RECUPERATION D'ENERGIE VIBRATOIRE PAR UN CONVERTISSEUR MECANIQUE/ELECTRIQUE**

SCHALTUNG ZUR OPTIMIERUNG DER WIEDERHERSTELLUNG EINER VIBRATIONSENERGIE DURCH EINEN MECHANISCH-ELEKTRISCHEN WANDLER

CIRCUIT FOR OPTIMIZING THE RECOVERY OF VIBRATORY ENERGY BY A MECHANICAL/ ELECTRICAL CONVERTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.01.2011 FR 1150531**

(43) Date de publication de la demande:
**04.12.2013 Bulletin 2013/49**

(73) Titulaire: **Commissariat à l'Énergie Atomique et aux Énergies Alternatives
75015 Paris (FR)**

(72) Inventeurs:
• **DESPESSE, Ghislain**
  **F-38120 Saint-Égrève (FR)**
• **AHMED SEDDIK, Bouhadjar**
  **F-38100 Grenoble (FR)**

(74) Mandataire: **Guérin, Jean-Philippe et al
Opilex
310 avenue Berthelot
69008 Lyon (FR)**

(56) Documents cités:
**WO-A1-2011/072770     FR-A1- 2 896 635
US-A1- 2003 067 245     US-A1- 2003 209 953
US-A1- 2010 102 673**

• WEN-PIN SHIH ET AL: "Tunable Capacitor Based on Polymer-Dispersed Liquid Crystal for Power Harvesting Microsystems", IEEE TRANSACTIONS ON ELECTRON DEVICES, IEEE SERVICE CENTER, PISACATAWAY, NJ, US, vol. 54, no. 10, 1 octobre 2008 (2008-10-01), pages 2568-2573, XP011235130, ISSN: 0018-9383, DOI: DOI:10.1109/TED.2008.2003226
• DAVIS CHRISTOPHER L ET AL: "An actively tuned solid-state vibration absorber using capacitive shunting of piezoelectric stiffness", JOURNAL OF SOUND & VIBRATION, LONDON, GB, vol. 232, no. 3, 4 mai 2000 (2000-05-04), pages 601-617, XP008117554, ISSN: 0022-460X, DOI: DOI:10.1006/JSVI.1999.2755 [extrait le 2002-03-19]
• DIBIN ZHU ET AL: "TOPICAL REVIEW; Strategies for increasing the operating frequency range of vibration energy harvesters: a review", MEASUREMENT SCIENCE AND TECHNOLOGY, IOP, BRISTOL, GB, vol. 21, no. 2, 1 février 2010 (2010-02-01), page 22001, XP020174402, ISSN: 0957-0233
• BEN-YAAKOV S ET AL: "New resonant rectifier for capacitive sources", ELECTRICAL AND ELECTRONICS ENGINEERS IN ISRAEL, 2004. PROCEEDINGS. 200 4 23RD IEEE CONVENTION OF TEL-AVIV, ISRAEL 6-7 SEPT. 2004, PISCATAWAY, NJ, USA,IEEE, US, 6 septembre 2004 (2004-09-06), pages 48-51, XP010742959, DOI: DOI:10.1109/EEEI.2004.1361085 ISBN: 978-0-7803-8427-9

**Description**

L'invention concerne les dispositifs de conversion d'énergie mécanique en énergie électrique, et en particulier les dispositifs d'alimentation autonome générant une énergie électrique à partir d'un mouvement vibratoire.

Dans certains environnements, il peut être délicat de connecter un circuit électrique à des câbles d'alimentation, par exemple dans des milieux hostiles ou sur des mécanismes en mouvement. Pour pallier ce problème, des dispositifs micromécaniques de conversion d'énergie vibratoire en énergie électrique sont connus. Ces dispositifs forment des microsystèmes généralement accolés sur des supports vibrants, tels que des machines ou des véhicules. Selon une technique connue, on utilise un système résonant pour amplifier une vibration mécanique d'un support et convertir le mouvement amplifié en électricité. Le circuit électrique peut ainsi être alimenté sans faire appel à des câbles provenant de l'extérieur.

Un des principes connus pour transformer de l'énergie mécanique vibratoire en énergie électrique est basé sur l'excitation vibratoire d'une poutre pourvue d'éléments piézo-électriques. Une telle poutre présente généralement un noyau ayant une première extrémité encastrée dans un support vibrant. Une masse mobile est fixée à la deuxième extrémité du noyau. Un élément piézo-électrique est fixé sur la face supérieure du noyau, un autre élément piézo-électrique est fixé sur la face inférieure du noyau. Un circuit électrique est connecté aux bornes des éléments piézo-électriques placés électriquement en série ou en parallèle. Les éléments piézoélectriques, sont destinés à convertir l'énergie mécanique transmise par la masse mobile en énergie électrique.

Un autre principe connu pour transformer de l'énergie mécanique vibratoire en énergie électrique est basé sur un système électrostatique. Le système électrostatique utilise une capacité variable pour convertir l'énergie mécanique vibratoire en énergie électrique.

Les problèmes récurrents avec les différents types de microstructures de récupération d'énergie restent la faible quantité d'énergie récupérée, la faible efficacité de la récupération d'énergie lorsque la fréquence des vibrations s'éloigne de la fréquence de résonance mécanique propre du système, et l'étroitesse de la bande passante de récupération d'énergie vibratoire.

Avec une structure piézo-électrique, afin d'accroître la bande passante des fréquences de vibrations générant de l'énergie électrique, la fréquence de résonance mécanique du système résonant peut être modifiée en contrôlant la polarisation d'un premier élément piézo-électrique, comme cela est présenté dans le rapport de thèse de David Charnegie intitulé 'FREQUENCY TUNING CONCEPTS FOR PIEZOELECTRIC CANTILEVER BEAMS AND PLATES FOR ENERGY HARVESTING'. L'énergie électrique est alors récupérée sur un deuxième élément piézo-électrique. La raideur du premier élément piézo-électrique peut ainsi être modifiée activement pour modifier la raideur de la poutre, et ainsi influer sur la fréquence de résonance mécanique. Pour cela, on connecte une capacité variable en parallèle avec le premier élément piézoélectrique. Le deuxième élément piézoélectrique n'étant pas connecté à la capacité variable, cette capacité variable n'affecte pas la récupération de l'énergie électrique dans la charge électrique.

On peut ainsi réaliser un asservissement de la fréquence de résonance mécanique du système. Un tel asservissement peut s'avérer nécessaire lorsque le système dont on extrait l'énergie vibratoire présente une fréquence vibratoire variable, par exemple sur un véhicule automobile dans lequel la vitesse de rotation du moteur ou la vitesse de rotation des roues connaît de grandes variations.

Si un tel système permet d'adapter la fréquence de résonance mécanique à la fréquence de la source de vibration, ce système n'optimise pas encore suffisamment la récupération d'énergie. Ce système ne permet notamment pas de garantir que l'amortissement électrique de la charge électrique est égal à l'amortissement mécanique de la poutre. La modification de l'impédance de la charge pour modifier la fréquence de résonance mécanique est en outre délicate à envisager sans perturber le fonctionnement de cette charge. Ce système ne permet pas non plus d'optimiser l'énergie récupérée des éléments piézo-électriques.

Le document «Tunable Capacitor Based on Polymer-Dispersed Liquid Crystal for Power Harvesting Microsystems » publié le 01/10/2008, décrit un condensateur réglable base sur du cristal liquide PDLC. Le document décrit l'intégration d'un tel condensateur dans un dispositif de récupération d'énergie vibratoire. Le rendement du dispositif de récupération d'énergie est amélioré en ajustant la fréquence de résonance d'une poutre piézoélectrique à la fréquence de vibration ambiante, au moyen du condensateur réglable.

L'invention vise à résoudre un ou plusieurs de ces inconvénients. L'invention porte ainsi sur un dispositif de conversion d'énergie mécanique vibratoire en énergie électrique, comprenant:

- un convertisseur générant une différence de potentiel lorsqu'il est soumis à des vibrations ;
- un circuit électrique connecté aux bornes du convertisseur et comprenant des première et deuxième branches en parallèle, la première branche comprenant un premier système de condensateur à capacité variable, la deuxième branche comprenant un deuxième système de condensateur à capacité variable en série avec une charge électrique à alimenter ;
- un circuit de commande configuré pour modifier les capacités respectives des premier et deuxième systèmes de condensateur de façon à modifier la fréquence de résonance mécanique du convertisseur.

Selon une variante, le convertisseur inclut au moins un système piézo-électrique déformé lors de l'application de vibrations.

Selon encore une variante, le système piézo-électrique est fixé sur une poutre présentant une première extrémité encastrée dans un support vibrant et une deuxième extrémité encastrée dans une masse mobile.

Selon une autre variante, le système piézo-électrique est polarisé dans la direction de la longueur de la poutre.

Selon encore une variante, le dispositif comprend en outre :

- un accéléromètre configuré pour mesurer l'accélération instantanée du support vibrant ;
- un dispositif de mesure de la tension instantanée aux bornes du système piézo-électrique ;

le circuit de commande étant configuré pour modifier les capacités respectives des premier et deuxième systèmes de condensateur de façon à maintenir la tension aux bornes du système piézo-électrique en quadrature de phase avec l'accélération du support vibrant.

Selon encore une variante, le dispositif comprend en outre un premier circuit comparateur générant un signal carré à partir de l'accélération instantanée mesurée et un deuxième circuit comparateur générant un signal carré à partir de la tension mesurée, un circuit de déphasage appliquant un déphasage de 90° à l'un des signaux carrés générés, le circuit de commande modifiant les capacités respectives des premier et deuxième systèmes de condensateur en fonction de la phase relative entre le signal déphasé généré à partir d'un signal carré et l'autre signal carré.

Selon encore une autre variante, le dispositif comprend en outre un premier circuit comparateur générant un signal carré à partir de l'accélération instantanée mesurée et un deuxième circuit comparateur générant un signal carré à partir de la tension mesurée, un circuit déterminant le rapport cyclique de recouvrement entre les signaux carrés générés, le circuit de commande modifiant les capacités respectives des premier et deuxième systèmes de condensateur en fonction du rapport cyclique de recouvrement déterminé.

Selon une autre variante, le dispositif comprend en outre un multiplicateur analogique multipliant l'accélération mesurée par la tension mesurée, le circuit de commande modifiant les capacités respectives des premier et deuxième systèmes de condensateur en fonction de la composante continue du signal de sortie du multiplicateur analogique.

Selon encore une autre variante, les premier et deuxième systèmes de condensateurs sont dimensionnés de sorte que le circuit de commande puisse faire varier la capacité équivalente Ce des première et deuxième branches en parallèle entre une valeur inférieure à $0,2*Cp$ et une valeur supérieure à $1,5*Cp$, avec Cp la capacité du système piézoélectrique.

Selon encore une autre variante, le dispositif comprend en outre: une source de tension continue à amplitude ajustable connectée en série avec le convertisseur, le circuit de commande étant configuré pour modifier l'amplitude de la source de tension continue.

Selon une autre variante, le convertisseur inclut au moins un électret et deux électrodes collectrices, l'électret étant déplacé par rapport à une des électrodes collectrices lors de l'application de vibrations.

Selon une variante, les premier et deuxième systèmes de condensateurs comprennent un ensemble de condensateurs, chacun des condensateurs de cet ensemble étant connecté en série avec un interrupteur respectif commandé par le circuit de commande.

Selon une autre variante :

- la première branche comprend un ensemble de n condensateurs C1i connectés en parallèle, i étant un entier compris entre 1 et n, chaque condensateur C1 i étant connecté en série avec un interrupteur respectif k1 i, les capacités des condensateurs C1 i étant définies par la relation
  $C1i=2^{i-1}*C\alpha$, avec $C\alpha$ une valeur de capacité de référence ;
- la deuxième branche comprend un ensemble de n condensateurs C2i connectés en parallèle, i étant un entier compris entre 1 et n, chaque condensateur C2i étant connecté en série avec un interrupteur respectif k2i, les capacités des condensateurs C2i étant définies par la relation
  $C2i=2^{i-1}*C\beta$, avec $C\beta$ une valeur de capacité de référence.

Selon encore une variante, le dispositif comprend un compteur numérique dont chaque bit de sortie commande un interrupteur respectif.

Selon encore une autre variante, le circuit de commande comprend un circuit de régulation configuré pour modifier les capacités des premier et deuxième systèmes de condensateurs de façon à optimiser la puissance dans la charge du circuit électrique.

Selon une variante, la différence de potentiel maximale générée par le convertisseur est au moins cinq fois supérieure à la différence de potentiel d'alimentation du circuit à alimenter.

D'autres caractéristiques et avantages de l'invention ressortiront clairement de la description qui en est faite ci-après, à titre indicatif et nullement limitatif, en référence aux dessins annexés, dans lesquels :

- la figure 1 est une vue en coupe longitudinale schématique d'un exemple de structure mécanique d'un dispositif de conversion d'énergie mécanique vibratoire selon l'invention ;
- la figure 2 est une vue de dessus du dispositif de la figure 1 ;
- la figure 3 est une représentation de principe du circuit électrique formé par un dispositif de conversion selon l'invention ;
- la figure 4 est une représentation schématique d'un premier mode de réalisation d'un circuit d'adaptation d'un dispositif de conversion ;
- la figure 5 est une représentation schématique d'un deuxième mode de réalisation d'un circuit d'adaptation d'un dispositif de conversion ;
- la figure 6 est une représentation schématique d'une première variante de circuit d'asservissement ;
- la figure 7 est une représentation schématique d'une deuxième variante de circuit d'asservissement ;
- la figure 8 est une représentation schématique d'une troisième variante de circuit d'asservissement ;
- la figure 9 est un diagramme illustrant la variation de la fréquence de résonance mécanique en fonction d'une valeur de capacité ;
- la figure 10 est un diagramme illustrant la variation de la capacité du circuit électrique en fonction des capacités dans les deux branches ;
- la figure 11 est une représentation de principe d'un perfectionnement du dispositif de conversion selon l'invention ;
- les figures 12 à 14 sont des représentations schématiques d'exemples de circuits d'asservissement selon un autre perfectionnement de l'invention ;
- la figure 15 est une représentation de principe d'un autre perfectionnement du dispositif de conversion selon l'invention.

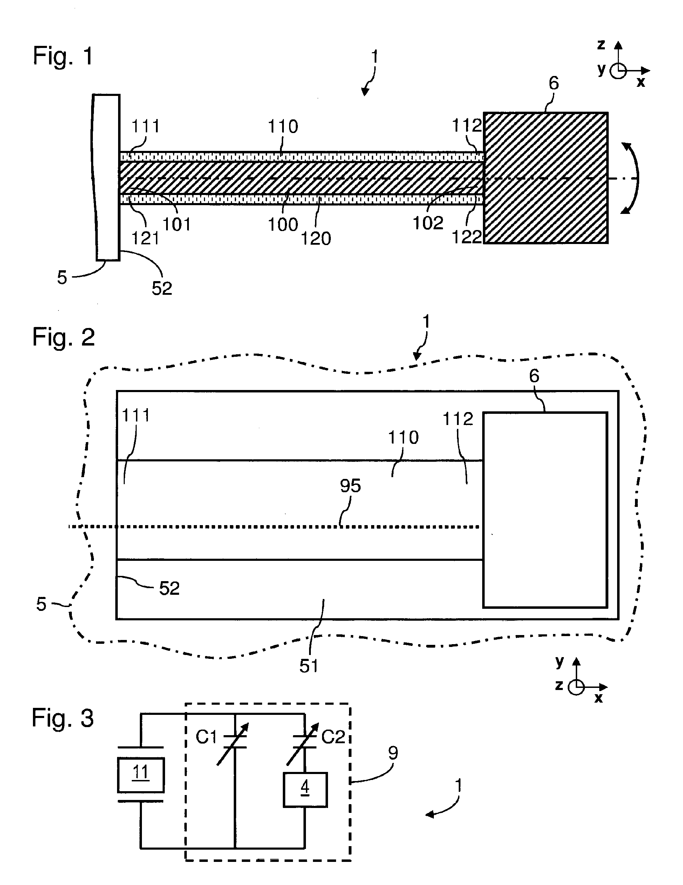

La figure 1 représente une vue en coupe longitudinale schématique d'un exemple de structure mécanique d'un dispositif de conversion d'énergie mécanique vibratoire en énergie électrique 1. La figure 2 est une vue de dessus du dispositif de conversion 1. Le dispositif 1 comprend un support 5 destiné à être solidarisé au système générateur de l'énergie mécanique vibratoire. Le dispositif 1 comprend également une masse mobile 6, logée dans un évidement 51 ménagé dans le support 5. Une poutre 100 s'étend longitudinalement (selon l'axe x dans le repère illustré) entre le support 5 et la masse mobile 6. La poutre 100 peut être une microstructure présentant une longueur inférieure à 10 mm. La poutre 100 présente deux extrémités longitudinales 101 et 102. Les extrémités 101 et 102 sont encastrées respectivement dans le support 5 et dans la masse mobile 6. La masse mobile 6 est maintenue suspendue par l'intermédiaire de la poutre 100 dans l'évidement 51 ménagé dans le support 5. La poutre 100 est configurée pour fléchir autour d'un axe de direction y sous l'effet du mouvement relatif entre la masse mobile 6 et le support 5 selon la direction z.

Avantageusement, le support 5, la masse mobile 6 et la poutre 100 sont formés d'un seul tenant dans un substrat de silicium (ou en acier). Une telle configuration peut être réalisée aisément avec des techniques connues de mise en forme du silicium ou de l'acier, en permettant d'obtenir des valeurs appropriées de modules d'élasticité pour un dispositif de conversion selon l'invention.

Avantageusement, la masse mobile 6 présente une masse nettement supérieure à la masse de la poutre 100. Ainsi, la fréquence de résonance mécanique peut être définie de façon plus aisée et l'énergie mécanique stockable (cinétique et potentielle) plus importante pour une même masse et un même déplacement en bout de poutre 100.

La poutre 100 comporte un élément piézo-électrique 110 fixé sur sa face supérieure, et un élément piézo-électrique 120 fixé sur sa face inférieure. Les éléments piézo-électriques 110 et 120 s'étendent longitudinalement entre le support 5 et la masse mobile 6. Les éléments piézo-électriques 110 et 120 présentent une polarisation sensiblement longitudinale. Ainsi, une tension électrique est générée entre leurs extrémités, respectivement 111 et 112, et 121 et 122 lorsqu'ils sont soumis à une traction ou une à compression longitudinale, induites par une flexion de la poutre 100.

La capacité électrique associée dans ce mode de réalisation est relativement faible et est proportionnelle à la section de l'élément piézo-électrique divisée par la longueur de la poutre. Il peut ainsi s'avérer avantageux que les éléments piézoélectriques présentent une polarisation transversale (axe z) afin de disposer d'une surface d'électrode relativement importante (faces inférieure et supérieure qui s'étendent sur toute la longueur de la poutre 100) avec une distance inter-électrodes relativement faible (l'épaisseur des éléments piézoélectriques est très inférieure à la longueur de la poutre). La tension générée étant proportionnelle à la distance inter-électrodes, une telle polarisation limite aussi les risques de claquages diélectriques.

L'extrémité 112 de l'élément piézo-électrique 110 est connectée à un circuit à alimenter et à un circuit d'adaptation (non illustrés) par l'intermédiaire d'un câblage électrique 95. L'extrémité 111 est connectée à la masse du circuit à alimenter et du circuit d'adaptation, par l'intermédiaire du support 5 formé dans un substrat semi-conducteur. De façon similaire, l'extrémité 122 de l'élément piézo-électrique 120 est connectée à la masse du circuit à alimenter. Un câblage électrique non illustré connecte l'extrémité 121 au circuit à alimenter et au circuit d'adaptation.

Dans l'exemple, la direction longitudinale est définie comme une direction perpendiculaire à la face 52 du support 5 sur laquelle la poutre 100 est fixée. La poutre 100 présente ici une structure relativement simple. On peut cependant également envisager des structures favorisant des contraintes homogènes dans les éléments piézoélectriques, comme cela est décrit dans le document 'Optimization of resonant harvesters in piezopolymercomposite technology' par Ms Goldschmidtboing et Muller distribué lors de la conférence PowerMEMS des 28 et 29 Novembre 2007.

Comme illustré à la figure 3, le système mécanique 11 (comportant la masse mobile 6, la poutre 100 et ses éléments piézo-électriques 110 et 120) génère une différence de potentiel entre deux bornes de connexion électrique. Ces bornes de connexion électrique sont connectées à un circuit électrique 9 comprenant une charge à alimenter 4 et des systèmes de condensateurs à capacité variable C1 et C2.

Les paramètres suivants seront utilisés par la suite :

fv fréquence de vibration du support 5 ;
frm fréquence de résonance mécanique de l'ensemble 11 ;
ξe l'amortissement électrique du dispositif de conversion 1 ;
ξm l'amortissement mécanique de l'ensemble 11 ;

Les systèmes de condensateurs à capacité variable C1 et C2 définissent à la fois l'amortissement électrique ξe du circuit 9 et la fréquence de résonance mécanique frm du système mécanique 11. Le circuit 9 comprend des première et deuxième branches connectées en parallèle aux bornes de connexion du système mécanique 11. La première branche inclut le système de condensateur C1 à capacité variable. La deuxième branche inclut le système de condensateur C2 à capacité variable, connecté en série avec la charge électrique 4 à alimenter. Dans un souci de simplification, la charge 4 est assimilée à une résistance pure.

Au moyen d'un circuit de commande non illustré, la capacité respective des systèmes de condensateur C1 et C2 est modifiée afin de définir une fréquence de résonance mécanique frm optimale du système 11 et afin d'obtenir un amortissement électrique ξe dans le dispositif de conversion 1 équivalent à l'amortissement mécanique du système 11. Ces deux conditions permettent de maximiser la puissance électrique au niveau de la charge, pour une amplitude de vibration et une masse mobile données. On peut également maintenir la différence de potentiel aux bornes de la charge 4 à une valeur optimale de fonctionnement. La récupération d'énergie électrique dans la charge 4 est alors optimisée tout en permettant un réglage satisfaisant de la fréquence de résonance mécanique frm. La fréquence de résonance mécanique frm ciblée par le circuit 9 peut par exemple être définie par une mesure de la fréquence de vibrations fv par un dispositif de mesure approprié non illustré.

La commande des valeurs de capacité respectives des condensateurs C1 et C2 permet d'ajuster la proportion de courant traversant la première branche et la proportion de courant traversant la deuxième branche (incluant la charge 4 à alimenter). La commande des valeurs de capacité respectives des systèmes de condensateur C1 et C2 pourra être effectuée par tout moyen approprié. Les valeurs des capacités pourront par exemple être définies dans des tables mémorisées dans le dispositif de conversion 1 en fonction de la fréquence de résonance mécanique souhaitée. Les valeurs des capacités des systèmes de condensateur C1 et C2 pourront également être définies par l'intermédiaire de boucles de régulation respectives.

En pratique, la variation de capacité du circuit 9, définie par la variation de capacité des systèmes de condensateur C1 et C2 modifie la distribution temporelle des charges électriques placées dans les éléments piézo-électriques 110 et 120. L'augmentation de la capacité du circuit 9 permet ainsi de réduire la raideur de la poutre 100 et ainsi d'abaisser la fréquence de résonance mécanique du système 11. La répartition de la capacité du circuit 9 entre les systèmes de condensateurs C1 et C2 permet d'ajuster l'amortissement électrique du circuit 9. L'augmentation de la capacité du système de condensateur C2 par rapport au système de condensateur C1 permet d'augmenter l'amortissement électrique du circuit 9.

L'amortissement électrique du dispositif de conversion 1 est en pratique défini par la relation suivante :

$$\xi_e = k^2 \frac{\sqrt{1 + \left(R * C_2 * \omega\right)^2}}{2\sqrt{\left(C_s^{'} + C_p^{'}\right)^2 + \left(R * C_2 * C_s^{'} * \omega\right)^2}}$$

Avec

ω la pulsation de la différence de potentiel généré définie par la fréquence de vibration fv) ;

R      la résistance de la charge électrique 4 ;

k      couplage électro-mécanique des éléments piézo-électriques ;

Cp      la capacité induite par les éléments piézo-électriques ;

$$C'p=1+(C1/Cp)$$

$$C's=C2/Cp$$

Avantageusement, la différence de potentiel pouvant être générée aux bornes du système 11 est très supérieure à la différence de potentiel de la charge 4 à alimenter. Les éléments piézo-électriques 110 et 120 pourront par exemple générer une différence de potentiel au moins 10 fois supérieure à la différence de potentiel appliquée sur la charge 4. La deuxième branche fonctionne alors en diviseur de tension pour pouvoir bénéficier de la différence de potentiel appropriée pour la charge 4 tout en permettant de faire varier la fréquence de résonance mécanique et l'amortissement électrique. Le rapport de division de tension pourra alors avantageusement varier. Une telle différence de potentiel permet de limiter l'incidence de la charge 4 (essentiellement résistive) sur la fréquence de résonance mécanique du système 11. On pourra par exemple prévoir des éléments piézo-électriques 110 et 120 permettant de générer une différence de potentiel de 50 V entre leurs bornes, pour une tension optimale aux bornes de la charge 4 de l'ordre de 3 V.

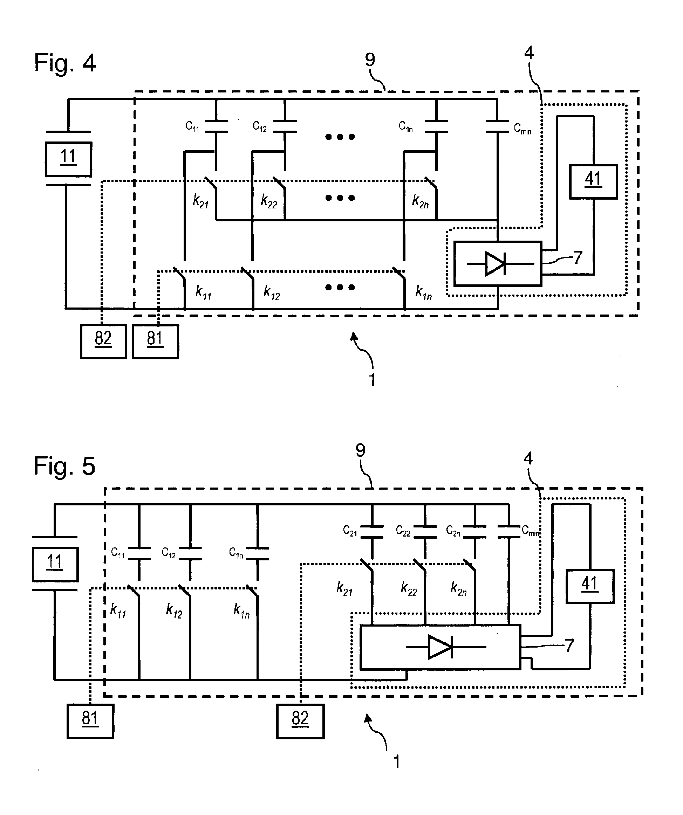

La figure 4 est une représentation schématique d'un premier mode de réalisation du circuit 9. La charge à alimenter 4 comprend d'une part un circuit consommateur 41 et un convertisseur alternatif/continu 7. Le convertisseur 7 reçoit en entrée une différence de potentiel alternative générée par le mouvement alternatif de la poutre 100. Le convertisseur 7 peut être mis en oeuvre sous forme de pont de diodes. La charge 4 comprend avantageusement un dispositif de stockage électrique (par exemple une batterie ou un condensateur) connecté à la sortie du convertisseur 7 pour stocker de l'énergie lorsque le circuit 41 est en veille. Le circuit 9 comprend par ailleurs un ensemble de condensateurs C11 à C1 n et Cmin présentant des premières électrodes connectées à une première borne du système 11. Les condensateurs C11 à C1 n et Cmin présentent par ailleurs des deuxièmes électrodes. Les deuxièmes électrodes des condensateurs C11 à C1 n sont connectées d'une part à une deuxième borne du système 11 par l'intermédiaire d'interrupteurs k11 à k1 n. Les deuxièmes électrodes des condensateurs C11 à C1 n sont connectées d'autre part à une entrée du convertisseur 7 par l'intermédiaire d'interrupteurs k21 à k2n. Les condensateurs C11 à C1 n peuvent ainsi être utilisés pour former une première branche en parallèle de la charge 4, ou pour être connectés en série avec la charge électrique 4 dans une deuxième branche. L'autre entrée du convertisseur 7 est connectée à la deuxième borne du système 11. L'ouverture ou la fermeture des interrupteurs k11 à k1 n est commandée par l'intermédiaire d'un circuit de commande 81. L'ouverture ou la fermeture des interrupteurs k21 à k2n est commandée par l'intermédiaire d'un circuit de commande 82. La fermeture sélective des interrupteurs k21 à k2n permet de disposer en série une capacité appropriée avec la charge 4. La fermeture sélective des interrupteurs k11 à k1 n permet de disposer une capacité appropriée en parallèle avec les électrodes des éléments piézoélectriques du système 11.

Pour permettre d'ajuster les valeurs de capacité en série ou en parallèle de la charge électrique de façon très précise, les condensateurs C11 à C1 n (ou C1i, avec i compris entre 1 et n) pourront présenter des valeurs de capacités définies par la relation suivante : $C1i = 2^{i-1}*C$, avec C une valeur de capacité de référence.

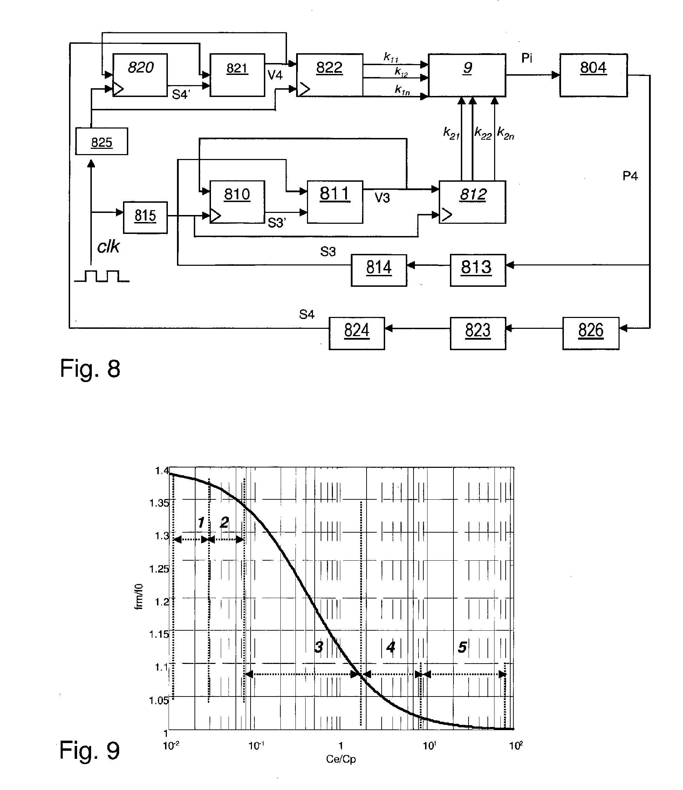

La présence du condensateur Cmin permet avantageusement de placer le circuit 9 au-delà d'une zone de saturation en disposant d'une capacité minimale en série avec la charge électrique 4, comme cela sera détaillé en référence au diagramme de la figure 9. Cette capacité permet par ailleurs de délivrer un minimum d'énergie sur la charge 4 avant même que les capacités C1i et C2i puissent être commandées. Ainsi, on peut prévoir au niveau de la charge 4 qu'un circuit prioritaire soit alimenté avec cette première énergie pour que ce circuit prioritaire puisse ensuite piloter de manière optimale les interrupteurs C1 i et C2i.

La figure 5 est une représentation schématique d'un deuxième mode de réalisation du circuit 9. La charge à alimenter 4 comprend d'une part un circuit consommateur 41 et un convertisseur alternatif/continu 7. Le convertisseur 7 reçoit en entrée une différence de potentiel alternative générée par le mouvement alternatif de la poutre 100.

Le circuit 9 comprend par ailleurs un ensemble de condensateurs C11 à C1 n présentant des premières électrodes connectées à une première borne du système 11. Les condensateurs C11 à C1 n présentent par ailleurs des deuxièmes électrodes connectées à une deuxième borne du système 11 par l'intermédiaire d'interrupteurs k11 à k1 n. Les condensateurs C11 à C1 n peuvent ainsi être connectés pour former une capacité appropriée dans une première branche, en parallèle avec les électrodes des éléments piézoélectriques.

Le circuit 9 comprend par ailleurs un ensemble de condensateurs C21 à C2n et Cmin présentant des premières électrodes connectées à une première borne du système 11. Les condensateurs C21 à C2n présentent par ailleurs des deuxièmes électrodes connectées à une entrée du convertisseur 7 par l'intermédiaire d'interrupteurs k21 à k2n. Le condensateur Cmin est connecté à cette même entrée du convertisseur 7. L'autre entrée du convertisseur 7 est connectée à la deuxième borne du système 11. Les condensateurs C21 à C2n et Cmin peuvent ainsi être connectés pour former une capacité appropriée en série avec la charge 4 dans une deuxième branche.

L'ouverture ou la fermeture des interrupteurs k11 à k1 n est commandée par l'intermédiaire d'un circuit de commande 81. L'ouverture ou la fermeture des interrupteurs k21 à k2n est commandée par l'intermédiaire d'un circuit de commande 82. La fermeture sélective des interrupteurs k21 à k2n permet de disposer en série une capacité appropriée avec la charge 4. La fermeture sélective des interrupteurs k11 à k1 n permet de disposer d'une capacité appropriée en parallèle avec les éléments piézoélectriques. Dans ce mode de réalisation, les condensateurs utilisés dans les deux branches sont dissociés.

Pour permettre d'ajuster les valeurs de capacité en série ou en parallèle de la charge électrique de façon très précise à partir d'une commande numérique, les condensateurs C11 à C1 n (ou C1i, avec i compris entre 1 et n) et C21 à C2n (ou C2i, avec i compris entre 1 et n) pourront présenter des valeurs de capacités définies par la relation suivante : $C1i=2^{i-1}*C\alpha$, $C2i=2^{i-1}*C\beta$, avec $C\alpha$ et $C\beta$ des valeurs de capacités de référence respectivement pour les systèmes C1 et C2.

La présence du condensateur Cmin permet avantageusement de placer le circuit 9 au-delà d'une zone de saturation en disposant d'une capacité minimale en série avec la charge électrique, comme cela sera détaillé en référence au diagramme de la figure 9. Cette capacité Cmin permet par ailleurs de délivrer un minimum d'énergie sur la charge avant même que les capacités C1i et C2i puissent être commandées. Ainsi, on peut prévoir au niveau de la charge qu'un circuit prioritaire soit alimenté avec cette première énergie pour que ce dernier puisse ensuite piloter de manière optimale les interrupteurs C1 i et C2i.

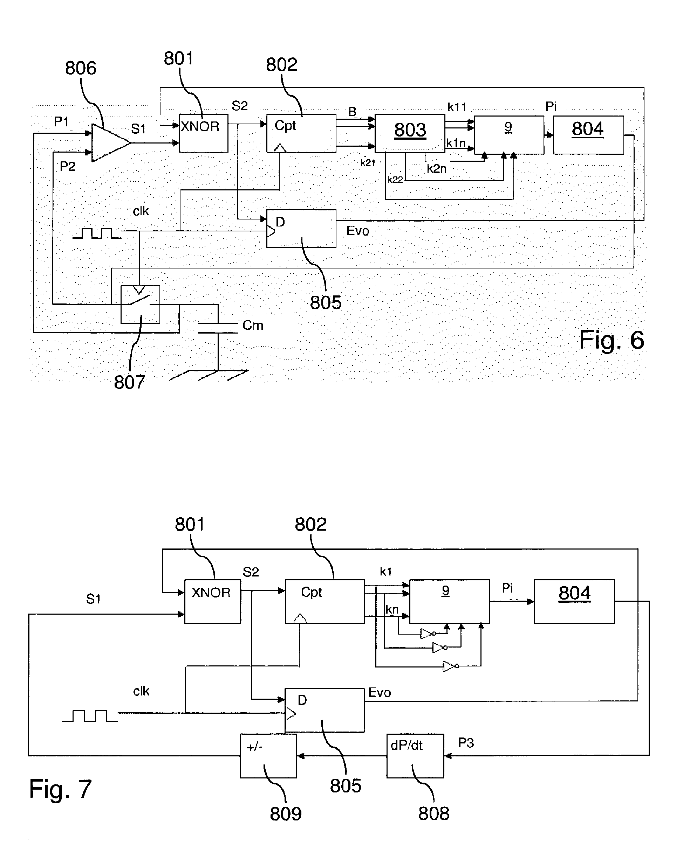

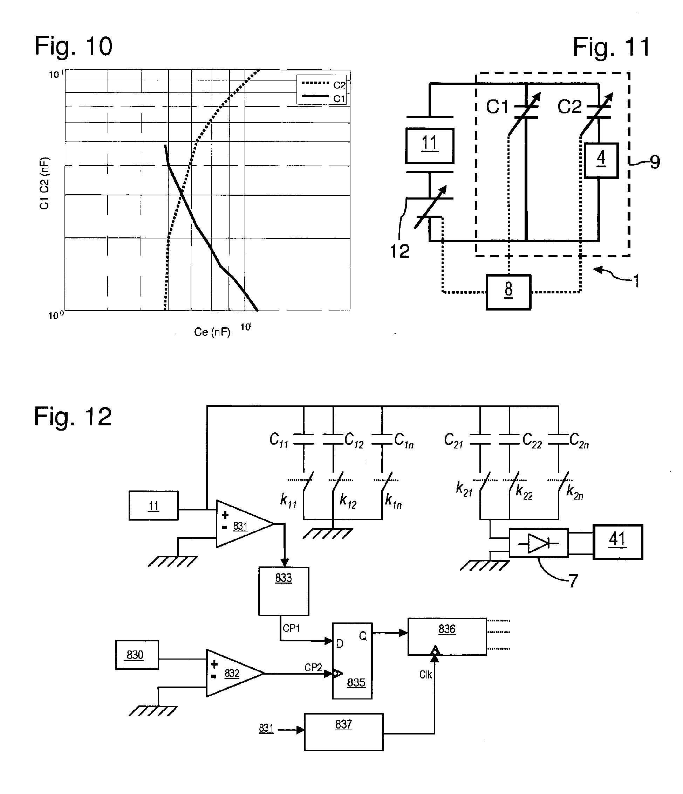

La figure 6 illustre un premier mode de réalisation d'un circuit de poursuite de la fréquence de résonance mécanique. Ce circuit est basé sur un asservissement direct de la puissance électrique débitée par le système 11 : la fréquence de résonance mécanique est ajustée automatiquement en optimisant en permanence la puissance électrique délivrée à la charge 4. On mesure la puissance instantanée Pi aux bornes de la charge 4 du circuit 9. La puissance mesurée est appliquée sur un filtre passe bas 804. Le filtre passe bas 804 fournit en sortie l'équivalent d'une moyenne glissante P2 de la puissance mesurée. La moyenne glissante P2 est appliquée sur une entrée d'un comparateur 806. Une valeur P1 de la moyenne glissante, préalablement mémorisée lors du cycle d'horloge précédant dans un condensateur de mémorisation Cm, est simultanément appliquée sur l'autre entrée du comparateur 806. Le comparateur 806 génère un signal S1. Le signal S1 vaut 1 si la puissance a augmenté, et 0 dans le cas contraire. Le signal S1 est appliqué sur une entrée d'une porte XNOR 801. Sur l'autre entrée de la porte XNOR 801, on applique le signal Evo représentant le signe de l'évolution précédente de la fréquence de résonance mécanique. Si le signal Evo est identique au signal S1, la porte 801 génère un signal S2 valant 1, sinon le signal S2 généré vaut 0. Le signal S2 est appliqué sur l'entrée d'un compteur 802. Le compteur 802 compte ou décompte selon que S2 vaut 0 ou 1. Le compteur 802 conserve en pratique le même sens de comptage si le comptage précédant a conduit à une augmentation de puissance ou change de sens de comptage si la puissance a au contraire diminué. La sortie du compteur 802 applique une valeur B sur l'entrée (bus d'adresse) d'une mémoire non volatile 803 (par exemple une mémoire EEPROM). La valeur de B correspond ainsi à une adresse de la mémoire non volatile 803. La mémoire non volatile 803 mémorise des configurations d'ouverture et de fermeture correspondantes à cette adresse. La mémoire non volatile 803 applique ainsi en sortie des signaux d'ouverture ou de fermeture des interrupteurs k11 à k1 n et k21 à k2n. Les capacités respectives dans les première et deuxième branches sont ainsi définies au moyen des configurations mémorisées dans la mémoire 803. Les critères de sélection de la proportion entre la capacité dans la première branche et la capacité dans la deuxième branche seront détaillés ultérieurement, en référence à la figure 10.

Lors du même front d'horloge qui ordonne au compteur 802 d'incrémenter ou de décrémenter sa valeur de sortie en fonction de la valeur de S2, un interrupteur 807 est transitoirement fermé pour mémoriser la valeur P2 dans le condensateur Cm, et ainsi disposer de la future valeur P1. La valeur du signal S2 est également mémorisée dans une bascule D 805 lors du même front d'horloge, pour générer le signal Evo suivant.

Un même signal d'horloge pilote l'interrupteur 807, la bascule D 805 et le compteur 802. Le signal d'horloge peut être généré à partir de la différence de potentiel aux bornes du système 11, de sorte qu'il est en phase avec la fréquence de vibration du système 5 et de sorte qu'il n'est pas nécessaire de prévoir un circuit d'horloge autonome. Les fronts montants et descendants du signal d'horloge peuvent être définis par le passage à zéro de la différence de potentiel aux bornes du système 11. Ainsi, on peut réaliser l'ouverture et la fermeture des interrupteurs k11 à k1 n et k21 à k2n à tension nulle, ce qui évite de transférer de façon intempestive des charges électriques des condensateurs vers les éléments piézo-électriques.

La figure 7 illustre un deuxième mode de réalisation d'un circuit de poursuite de la fréquence de résonance mécanique, présentant une structure simplifiée. Ce circuit est basé sur un asservissement direct de la puissance électrique débitée par le système 11. On mesure la puissance instantanée Pi aux bornes du circuit 9. La puissance mesurée est appliquée sur un filtre passe bas 804. Le filtre passe bas 804 fournit en sortie l'équivalent d'une moyenne glissante P3 de la puissance mesurée. La moyenne glissante P3 est appliquée sur un circuit dérivateur 808. Le signal de sortie du circuit dérivateur 808 est appliqué sur l'entrée d'un circuit 809 (un comparateur par rapport à zéro) identifiant le signe de la dérivée du signal P3. Un signal S1 correspondant au signe identifié est généré sur la sortie du circuit 809. Le signal S1 vaut 1 si la puissance a augmenté, et 0 dans le cas contraire. Le signal S1 est appliqué sur une entrée d'une porte XNOR 801. Sur l'autre entrée de la porte XNOR 801, on applique le signal Evo représentant la valeur précédente de S2 représentative de l'évolution précédente d'un compteur 802 dont la sortie ajuste la fréquence de résonance mécanique.

Si le signal Evo est identique au signal S1, la porte 801 génère un signal S2 valant 1, sinon le signal S2 généré vaut 0. Le signal S2 est appliqué sur l'entrée du compteur 802. La sortie du compteur 802 commande directement l'ouverture ou la fermeture des interrupteurs k11 à k1 n et k21 à k2n. Le signal de commande appliqué sur un interrupteur k1 i est le complémentaire du signal de commande appliqué sur un interrupteur k2i. Ainsi, lorsque C1 augmente, on diminue C2, comme illustré ultérieurement en référence à l'exemple de la figure 10. Réciproquement, lorsque C1 diminue, C2 augmente.. Un tel circuit de commande s'avère ainsi particulièrement simple. De tels signaux de commande sont avantageusement utilisés avec des condensateurs respectant la relation définie précédemment: $C1i=2^{i-1}*C\alpha$, $C2i=2^{i-1}*C\beta$. Les valeurs de $C\alpha$ et $C\beta$ permettent notamment d'ajuster la pente d'évolution de C1 et de C2.

Lors du même front d'horloge qui ordonne au compteur 802 d'incrémenter ou de décrémenter sa valeur de sortie en fonction de la valeur de S2, la valeur du signal S2 est mémorisée dans une bascule D 805, pour générer le signal Evo suivant.

Un même signal d'horloge pilote la bascule D 805 et le compteur 802. Le signal d'horloge peut être généré à partir de la différence de potentiel aux bornes du système 11, de sorte qu'il est en phase avec la fréquence de vibration du système 5 et ne nécessite pas la génération d'un signal d'horloge autonome.

La figure 8 illustre un troisième mode de réalisation d'un circuit de poursuite de la fréquence de résonance mécanique. Ce circuit est basé sur un asservissement différencié de la fréquence de résonance et de l'amortissement électrique.

On mesure la puissance instantanée Pi aux bornes du circuit 9. La puissance mesurée est appliquée sur un premier filtre passe bas 804. Le filtre passe bas 804 fournit en sortie l'équivalent d'une moyenne glissante P4 de la puissance mesurée. La moyenne glissante P4 est appliquée d'une part sur un circuit dérivateur 813, et d'autre part sur une entrée d'un autre circuit passe-bas 826.

Le signal de sortie du circuit dérivateur 813 est appliqué sur l'entrée d'un circuit 814 identifiant le signe de la dérivée du signal P4. Un signal S3 correspondant au signe identifié est généré sur la sortie du circuit 814. Le signal S3 vaut 1 si la puissance a augmenté, et 0 dans le cas contraire. Le signal S3 est appliqué sur une entrée d'une porte XNOR 811. Sur l'autre entrée de la porte XNOR 811, on récupère une valeur précédente S3', mémorisée dans une bascule D 810.

Si le signal S3' est identique au signal S3, la porte 811 génère un signal V3 valant 1, sinon le signal V3 généré vaut 0. Le signal V3 est appliqué sur l'entrée d'un compteur 812. La sortie du compteur 812 codé en binaire sur n bits et transitant sur n fils commande directement l'ouverture ou la fermeture des interrupteurs k21 à k2n et permet donc de gérer principalement l'amortissement électrique du circuit 9.

La sortie du circuit passe-bas 826 est appliquée sur une entrée d'un circuit dérivateur 823. Le signal de sortie du circuit dérivateur 823 est appliqué sur l'entrée d'un circuit 824 identifiant le signe de la dérivée du signal issu du circuit 826. Un signal S4 correspondant au signe identifié est généré sur la sortie du circuit 824. Le signal S4 vaut 1 si la puissance a augmenté, et 0 dans le cas contraire. Le signal S4 est appliqué sur une entrée d'une porte XNOR 821. Sur l'autre entrée de la porte XNOR 821, on récupère une valeur précédente S4', mémorisée dans une bascule D 820.

Si le signal S4' est identique au signal S4, la porte 821 génère un signal V4 valant 1, sinon le signal V4 généré vaut 0. Le signal V4 est appliqué sur l'entrée d'un compteur 822. La sortie du compteur 822 commande directement l'ouverture ou la fermeture des interrupteurs et k11 à k1 n et permet donc de gérer principalement la fréquence de résonance du système 11.

Le signal d'horloge est appliqué sur un diviseur de fréquence 815 et sur un diviseur de fréquence 825. Les signaux d'horloge issus du diviseur 815 sont appliqués sur la porte 811 et sur le compteur 812. Les signaux d'horloge issus du diviseur 825 sont appliqués sur la porte 821 et sur le compteur 822. La division de fréquence par le diviseur 815 est supérieure à la division de fréquence par le diviseur 825, par exemple d'un facteur 10. Il est avantageux d'asservir la fréquence de résonance et l'amortissement électrique avec des boucles d'asservissement présentant des temps de réponse distincts, afin d'éviter la formation d'un système instable. Par ailleurs, le temps de réponse de la fréquence de résonance à une modification de capacité est plus élevé que pour la valeur de l'amortissement, ce qui justifie l'utilisation d'un temps de rétroaction dans la boucle d'asservissement de la fréquence plus important, cette augmentation du temps de rétroaction est introduite par le deuxième filtre passe-bas 826 et par une division plus importante du signal d'horloge par le diviseur 815.

Lors de leur front d'horloge, les bascules D 810 et 820 mémorisent respectivement la valeur du signal V3 et du signal V4 pour leur application ultérieure sur une entrée respectivement de la porte 811 et de la porte 821. Les compteurs 812 et 822 incrémentent ou décrémentent respectivement leur valeur de sortie sur le même front d'horloge en fonction des valeurs V3 et V4.

Le diagramme de la figure 9 illustre un exemple de variation de la fréquence de résonance mécanique frm en fonction des valeurs de capacité appliquées à l'intérieur du circuit 9. Plus précisément, on a illustré en abscisse le rapport entre la capacité équivalente Ce (capacité équivalente aux branches incluant les systèmes de condensateurs C1 et C2) et la capacité Cp induite par les éléments piézo-électriques 110 et 120 de la poutre 100. frm est exprimée comme une proportion de la fréquence de résonance mécanique minimale f0 du système 11. La variation de la fréquence de résonance mécanique est représentative de la variation de la raideur de la poutre 100 via la modification de la raideur des éléments piézoélectriques 110 et 120 par la modification de la charge électrique.

Le diagramme illustré présente 5 zones. Les zones 1 et 5 correspondent à des zones de saturation, se rapprochant respectivement de conditions de circuit ouvert et de conditions de court-circuit. La présence du condensateur Cmin en série avec la charge 4 permet d'éviter la zone de saturation 1. Les zones 2 et 4 correspondent à des zones non linéaires du circuit. La zone 3 correspond à une zone relativement linéaire avec une pente élevée. Le circuit 9 est plus facilement commandé si on limite le fonctionnement à la zone linéaire 3 du diagramme. Un fonctionnement du circuit 9 dans la zone linéaire 3 peut être obtenu par un dimensionnement approprié des systèmes de condensateurs C1 et C2, par rapport à la capacité Cp. Comme illustré sur le diagramme, on peut rester dans la zone linéaire 3 si la capacité équivalente Ce varie entre 0,1 *Cp et 2*Cp.

Toutefois, pour augmenter l'excursion en fréquence du système, il peut être judicieux d'utiliser également les zones 2 et 4. On prend alors avantageusement en compte l'aspect non-linéaire dans l'étude de la stabilité du/des boucles d'asservissement pour dimensionner les éléments de la/des boucles (fréquence d'horloge, pas de quantification de la capacité, ordre et fréquence de coupure des filtres, correcteur éventuel...). L'utilisation d'une mémoire, comme dans le cas de la figure 6, peut faciliter la correction de cette non linéarité.

Par ailleurs, afin de limiter l'impact des capacités parasites sur le fonctionnement du dispositif de conversion 1, il est avantageux que la capacité Cp ait une valeur la plus élevée possible. À cet effet, il est souhaitable que les éléments piézo-électriques 110 et 120 soient polarisés selon leur direction transversale si la longueur de ces éléments est importante par rapport à leur épaisseur. Si la longueur de ces éléments est réduite par rapport à leur épaisseur, il est souhaitable que les éléments piézo-électriques soient polarisés selon leur direction longitudinale, ce qui offre un meilleur couplage électromécanique. Pour satisfaire à la fois une longueur de poutre importante et bénéficier d'un couplage électromécanique élevé sans trop réduire la capacité, il peut s'avérer avantageux d'accoler plusieurs éléments piézo-électriques dans la longueur de la poutre, ces éléments piézo-électriques présentant chacun une polarisation selon cette longueur.

La figure 10 est un diagramme illustrant les valeurs de capacités respectives optimales C1 et C2 en fonction de la capacité équivalente Ce du circuit 9. Ce diagramme peut avantageusement servir à définir les valeurs de capacités optimales pour C1 et C2, afin de déterminer les interrupteurs à ouvrir ou fermer dans le mode de réalisation de la figure 6, dans lequel ces interrupteurs sont commandés par les valeurs stockées dans la mémoire non volatile 803.

Ce diagramme peut être utilisé pour réguler le fonctionnement du dispositif de conversion 1 de la façon suivante :

on détermine tout d'abord la capacité équivalente nécessaire pour ajuster la fréquence de résonance mécanique sur la fréquence de vibration. On détermine ensuite le rapport entre les capacités C1 et C2 permettant de définir le coefficient d'amortissement électrique optimal.

En pratique, dans le cas des figures 6, 7 et 8, c'est la valeur de sortie du compteur qui est une image de la capacité totale souhaitée, une incrémentation ou une décrémentation du compteur signifiant une augmentation ou une diminution de la capacité totale. Ensuite, c'est la mémoire (fig. 6), les pas d'incrémentation et décrémentation parallèles (fig. 7) ou encore la deuxième boucle d'asservissement (fig. 8) qui permettent de répartir cette capacité globale entre C1 et C2.

La figure 11 illustre un perfectionnement d'un dispositif de conversion selon l'invention. Comme dans les exemples précédents, le système mécanique 11 (comportant la masse mobile 6, la poutre 100 et ses éléments piézo-électriques 110 et 120) génère une différence de potentiel entre deux bornes de connexion électrique. Un dispositif d'ajustement 12 comporte une source de tension continue à amplitude réglable, connectée en série avec le système mécanique 11. Un circuit électrique 9 comprenant une charge à alimenter 4 et des systèmes de condensateurs à capacité variable C1 et C2 sont connectés aux bornes de l'ensemble formé du système mécanique 11 et du dispositif d'ajustement 12. Un dispositif de commande 8 contrôle les capacités respectives des condensateurs C1 et C2. Le dispositif de commande 8 contrôle le champ électrique appliqué sur le système 100 par le dispositif d'ajustement 12.

Le principe de ce perfectionnement consiste à appliquer un champ électrique statique (mais d'amplitude réglable) dans le matériau piézoélectrique des éléments piézo-électriques 110 et 120 du système mécanique 11. L'application d'un mouvement mécanique alternatif sur le support vibrant engendre une variation de champ électrique dans les éléments piézoélectriques qui se superpose au champ électrique statique qu'impose le dispositif d'ajustement 12. Ce champ électrique statique permet d'augmenter ou de baisser la raideur, selon son sens d'application par rapport à la polarisation du matériau piézoélectrique. On peut ainsi encore élargir la plage de variation de la fréquence de résonance mécanique et donc utiliser une très large gamme de fréquences de vibration pour récupérer de l'énergie. Le dispositif de commande 8 contrôle ainsi la fréquence de résonance du système mécanique 11 en fonction de la tension appliquée par le dispositif d'ajustement 12 (en complément de son action sur les valeurs des capacités C1 et C2 qui influent aussi sur la fréquence de résonance du système mécanique 11). Une résistance R de valeur élevée (R au moins dix fois supérieure à $1/(C1 * \omega)$ par exemple) peut être disposée en parallèle de C1 de façon à maintenir aux bornes de celle-ci une tension moyenne sensiblement nulle (suppression de la composante continue qui pourrait apparaître aux bornes de C1 et modifier ainsi le champ électrique moyen que l'on cherche à appliquer au sein du système 11).

Selon un autre perfectionnement, on maintient constant un déphasage entre la tension générée par les éléments piézoélectriques 110 et 120 et l'accélération du support 5. L'objectif de cette stratégie est de maintenir le système 11 en fonctionnement à sa fréquence de résonance en se basant sur une mesure d'écart entre les phases à l'origine des tensions respectives des éléments piézoélectriques 110 et 120 et de l'accélération du support vibrant. Les phases de ces tensions seront désignées respectivement par p1 et p2.

A la résonance, la différence de phase entre un de ces signaux de tension et le signal représentatif de l'accélération est égale à $\pi/2$ (quadrature de phase), ces deux signaux tendent à être en phase lorsque la fréquence d'excitation est très supérieure à la fréquence de résonance du système 11, et ces deux signaux tendent à être en opposition de phase lorsque la fréquence d'excitation est inférieure à la fréquence de résonance.

Le perfectionnement vise à réaliser un système de rétroaction qui permet de maintenir la différence de phase autour de $\pi/2$, c'est-à-dire de maintenir le système en résonance.

Selon un premier mode de réalisation de ce perfectionnement illustré à la figure 12, on crée deux signaux carrés respectivement à partir d'une tension représentative de l'accélération du support 5 et à partir de la tension aux bornes des éléments piézo-électriques du système 11. Un accéléromètre 830 applique un signal représentatif de l'accélération du support 5 sur l'entrée non inverseuse d'un comparateur 832. La tension aux bornes du système 11 (ou la tension filtrée par un filtre passe haut en présence d'un dispositif d'ajustement du champ statique 12, ou la tension aux bornes de la capacité C1,) est appliquée sur l'entrée non inverseuse d'un comparateur 831 (une atténuation de la tension d'entrée peut également être effectuée, par exemple via un pont diviseur résistif, pour éviter d'avoir à alimenter le comparateur avec une tension aussi élevée que la tension de sortie du système 11).

Le signal carré fourni en sortie par le comparateur 832 est utilisé comme une horloge pour la bascule D 835. Le signal carré, fourni en sortie du comparateur 831, est appliqué sur l'entrée d'un circuit d'avance de phase 833. Le circuit d'avance de phase 833 applique une avance de phase de $\pi/2$ sur le signal d'entrée. Le signal de sortie est appliqué à l'entrée D de la bascule 835. La bascule D 835 sert à comparer la position de la fréquence de vibration par rapport à la fréquence de résonance, avec un décalage de $\pi/2$.

Au moment du front montant du signal de sortie du comparateur 831, on peut avoir deux cas distincts :

Soit la fréquence d'excitation du support 5 est supérieure à la fréquence de résonance, alors dans ce cas le signal du comparateur 831 est en retard de phase de plus de $\pi/2$ par rapport au signal du comparateur 832. Dans ce cas, on procède à l'augmentation de la fréquence de résonance jusqu'au changement de signe.

Soit la fréquence d'excitation du support 5 est inférieure à la fréquence de résonance, alors dans ce cas là le signal du comparateur 831 est en retard de phase de moins de $\pi/2$ par rapport au signal du comparateur 832. Dans ce cas, on procède à la diminution de la fréquence de résonance jusqu'au changement de signe.

La sortie de la bascule D 835 est connectée directement à l'entrée d'un compteur 836. Cette entrée sert à définir le sens de comptage. L'entrée d'horloge du compteur 836 est commandée par une sortie d'un diviseur de fréquence 837 pour réduire la fréquence de comptage et par suite la consommation du système (le facteur de division est un compromis à trouver entre la vitesse de rétroaction du système et sa consommation. Un dimensionnement optimal consiste à donner au système juste la dynamique nécessaire pour suivre la variation de la fréquence de la vibration d'entrée, vitesse de variation qui dépend fortement du type de vibration à récupérer). La sortie du comparateur 831 est appliquée sur l'entrée du diviseur de fréquence 837. Le compteur 836 commande les interrupteurs k1 n et k2n définissant les valeurs des capacités C1 et C2.

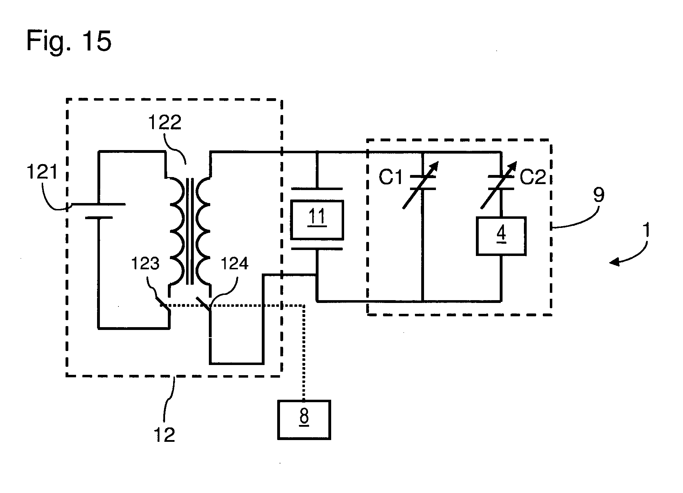

On pourrait envisager que le compteur 836 puisse, additionnellement, en alternance ou en remplacement, commander une augmentation ou une diminution d'un champ statique dans le dispositif 12. Ce peut être soit une valeur de champ directement proportionnelle à la valeur du compteur, soit les bits de poids fort qui gèrent la valeur du champ appliqué et les bits de poids faible qui gèrent les capacités C1 et C2. Le champ statique du dispositif 12 peut aussi être géré par des incréments/décréments d'énergie électrique dans le dispositif 12, au lieu d'incrémenter un compteur, on envoie une petite impulsion d'énergie vers le dispositif 12 et inversement, au lieu de décrémenter un compteur, on retire une petite impulsion d'énergie du dispositif 12. Un tel dispositif de conversion est illustré à la figure 15. Le dispositif 12 inclut une alimentation 121 connectée au primaire d'un convertisseur à découpage de type flyback 122. Le secondaire du convertisseur 122 est connecté aux bornes des éléments piézo-électriques du système 11. Le circuit de commande 8 commande des interrupteurs 123 et 124 connectés en série avec respectivement le primaire et le secondaire du convertisseur 122 pour retirer ou envoyer une impulsion d'énergie électrique dans les éléments piézo-électriques du système 11.

A chaque front montant du signal de régulation on incrémente ou on décrémente la fréquence de résonance de $\Delta f$. Dans les deux cas de figure décrits ci-dessus, f<f0 ou f>f0 (avec f la fréquence de vibration du support 5 et f0 la fréquence de résonance du système), le système se stabilise autour de f0, (de f0-$\Delta f$ à f0 +$\Delta f$).

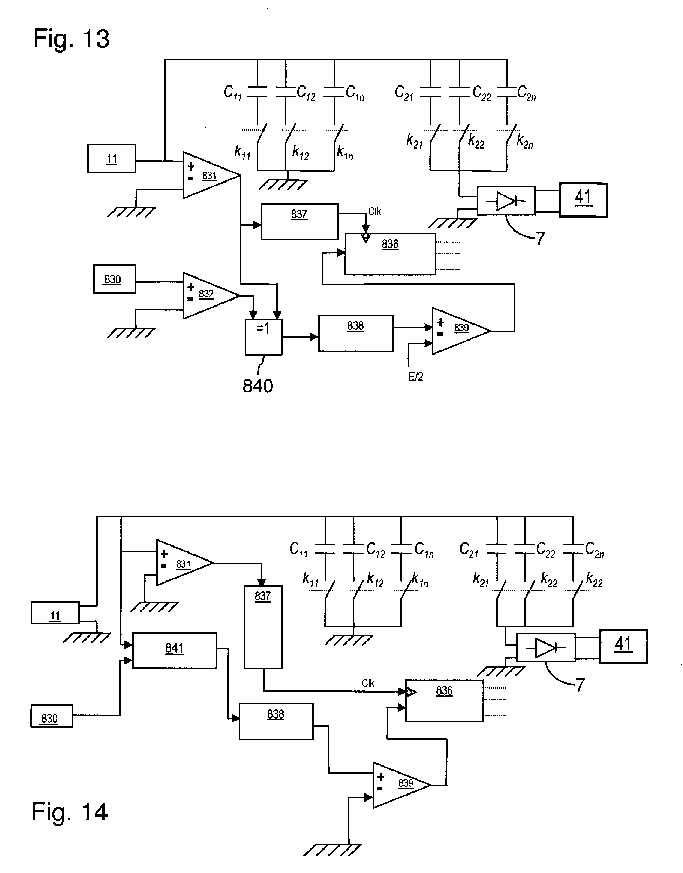

Selon un deuxième mode de réalisation de ce perfectionnement illustré à la figure 13, on crée deux signaux carrés respectivement à partir d'une tension représentative de l'accélération du support 5 et à partir de la tension aux bornes des éléments piézo-électriques du système 11. Un accéléromètre 830 applique un signal représentatif de l'accélération du support vibrant 5 sur l'entrée non inverseuse d'un comparateur 832. La tension aux bornes du système 11 est appliquée sur l'entrée non inverseuse d'un comparateur 831.

Les signaux carrés de sortie des comparateurs 831 et 832 sont appliquées sur l'entrée d'une porte XNOR 840. La sortie de la porte 840 est connectée à l'entrée d'un filtre passe bas 838. Le signal de sortie de ce filtre 838 représente la moyenne de la tension en sortie de la porte XNOR 840. Cette moyenne U est typiquement calculée sur un cycle de 10 périodes de vibration mécanique. Cette moyenne de tension U est proportionnelle au déphasage entre les créneaux à la sortie des comparateurs 831 et 832. La sortie du filtre 838 est appliquée sur l'entrée non inverseuse d'un comparateur 839. Une tension E/2 est appliquée sur l'entrée inverseuse du comparateur 839. La tension E correspond à la tension d'alimentation de la porte XNOR 840 et donc à la valeur maximale que peut atteindre la tension U.

Si f<f0 : U > E/2 ($\Delta\omega > \pi/2$)
Si f=f0 : U = E/2 ($\Delta\omega = \pi/2$)
Si f>f0 : U < E/2 ($\Delta\omega < \pi/2$)

La sortie du comparateur 839 est connectée directement à l'entrée d'un compteur 836. Cette entrée sert à définir le sens de comptage. L'entrée d'horloge du compteur 836 est commandée par une sortie d'un diviseur de fréquence 837. La sortie du comparateur 831 est appliquée sur l'entrée du diviseur de fréquence 837. Le compteur 836 commande les interrupteurs k1 n et k2n définissant les valeurs des capacités C1 et C2.

Le but est de positionner la fréquence de résonance le plus proche possible de la fréquence de vibration du support vibrant 5. La tension U est donc comparée à la tension E/2. Dans le cas où U>E/2, on diminue la fréquence de résonance, dans le cas où U<E/2, on augmente la fréquence de résonance.

Selon un troisième mode de réalisation de ce perfectionnement illustré à la figure 14, on applique une tension représentative de l'accélération du support vibrant 5 et la tension aux bornes des éléments piézo-électriques du système 11 sur des entrées respectives d'un circuit multiplicateur 841. Le circuit multiplicateur 841 réalise une multiplication analogique de ces deux tensions. Le signal de sortie du multiplicateur 841 comporte ainsi une composante continue et une composante alternative. La composante alternative a une fréquence égale au double de la fréquence de vibration. La composante continue est représentative du déphasage entre les deux tensions. On peut réaliser une moyenne du signal de sortie du multiplieur 841, par exemple sur une dizaine de périodes de vibration mécanique, et ainsi extraire la composante continue image du déphasage. La sortie du multiplicateur 841 est appliquée sur un filtre 838. Le filtre 838 élimine la composante alternative et applique la composante continue sur sa sortie. La sortie du filtre 838 est appliquée sur l'entrée non inverseuse d'un comparateur 839.

Conformément à l'équation ci-dessous, le système rentre en résonance lorsque la composante continue est nulle car les tensions sont alors en quadrature de phase.

$$V_{841}(t)=V_{830}(t) * V_{11}(t)=0.5 V_{acc830}.V_{11} * \cos(\Delta\omega)+\cos(2\varpi t+\omega_1+\omega_2)$$

A l'aide du comparateur 839, on cherche à stabiliser le système au point où la composante continue en sortie du multiplicateur 840 reste la plus proche possible de zéro. La sortie du comparateur 839 est connectée directement à l'entrée de commande du sens de comptage d'un compteur 836.

La tension aux bornes du système 11 est appliquée sur l'entrée non inverseuse d'un comparateur 831. L'entrée d'horloge du compteur 836 est commandée par une sortie d'un diviseur de fréquence 837. La sortie du comparateur 831 est appliquée sur l'entrée du diviseur de fréquence 837. Le compteur 836 commande les interrupteurs k1 n et k2n définissant les valeurs des capacités C1 et C2.

En fonction de la position de la fréquence de résonance par rapport à la fréquence de vibration, le comparateur 839 modifie le sens de comptage.

Dans les exemples présentés précédemment, le système de conversion d'énergie mécanique en énergie électrique est basé sur une poutre munie d'éléments piézo-électriques. L'invention s'applique également à tout autre système de conversion d'énergie vibratoire en énergie électrique, par exemple un système électrostatique.

Le système électrostatique peut comporter deux électrodes en vis-à-vis mobiles l'une par rapport à l'autre sous l'effet de vibration. Le système électrostatique peut être basé soit sur une recharge des électrodes par une alimentation, soit être basé sur la présence d'un électret mobile par rapport à au moins une des électrodes.

**Revendications**

1. Dispositif de conversion d'énergie mécanique vibratoire en énergie électrique (1), comprenant:

   - un convertisseur (11) générant une différence de potentiel lorsqu'il est soumis à des vibrations ;
   - un circuit électrique (9) connecté aux bornes du convertisseur et comprenant des première et deuxième branches en parallèle, la première branche comprenant un premier système de condensateur à capacité variable (C1), la deuxième branche comprenant une charge électrique (4) à alimenter ; **Caractérisé en ce que** :
   - la deuxième branche comprend un deuxième système de condensateur à capacité variable (C2) en série avec la charge électrique (4) ;
   - un circuit de commande (81,82) configuré pour modifier les capacités respectives des premier et deuxième systèmes de condensateur de façon à modifier la fréquence de résonance mécanique du convertisseur.

2. Dispositif de conversion d'énergie mécanique vibratoire en énergie électrique selon la revendication 1, dans lequel le convertisseur (11) inclut au moins un système piézo-électrique (110, 120) déformé lors de l'application de vibrations.

3. Dispositif de conversion d'énergie mécanique vibratoire en énergie électrique selon la revendication 2, dans lequel le système piézo-électrique est fixé sur une poutre (100) présentant une première extrémité encastrée dans un support vibrant (5) et une deuxième extrémité encastrée dans une masse mobile (6).

4. Dispositif de conversion d'énergie mécanique vibratoire en énergie électrique selon la revendication 3, dans lequel le système piézo-électrique (110, 120) est polarisé dans la direction de la longueur de la poutre (100).

5. Dispositif de conversion d'énergie mécanique vibratoire en énergie électrique selon la revendication 3 ou 4, comprenant en outre :

   - un accéléromètre (830) configuré pour mesurer l'accélération instantanée du support vibrant (5) ;
   - un dispositif de mesure de la tension instantanée aux bornes du système piézo-électrique ;

   le circuit de commande (8) étant configuré pour modifier les capacités respectives des premier et deuxième systèmes de condensateur de façon à maintenir la tension aux bornes du système piézo-électrique en quadrature de phase avec l'accélération du support vibrant (5).

6. Dispositif de conversion d'énergie mécanique vibratoire en énergie électrique selon la revendication 5, comprenant un premier circuit comparateur générant un signal carré à partir de l'accélération instantanée mesurée et un deuxième circuit comparateur générant un signal carré à partir de la tension mesurée, un circuit de déphasage appliquant un déphasage de 90° à l'un des signaux carrés générés, le circuit de commande (8) modifiant les capacités respectives des premier et deuxième systèmes de condensateur en fonction de la phase relative entre le signal déphasé généré à partir d'un signal carré et l'autre signal carré.

7. Dispositif de conversion d'énergie mécanique vibratoire en énergie électrique selon la revendication 5, comprenant un premier circuit comparateur générant un signal carré à partir de l'accélération instantanée mesurée et un deuxième circuit comparateur générant un signal carré à partir de la tension mesurée, un circuit (840) déterminant le rapport cyclique de recouvrement entre les signaux carrés générés, le circuit de commande (8) modifiant les capacités respectives des premier et deuxième systèmes de condensateur en fonction du rapport cyclique de recouvrement déterminé.

8. Dispositif de conversion d'énergie mécanique vibratoire en énergie électrique selon la revendication 5, comprenant un multiplicateur analogique multipliant l'accélération mesurée par la tension mesurée, le circuit de commande (8) modifiant les capacités respectives des premier et deuxième systèmes de condensateur en fonction de la composante continue du signal de sortie du multiplicateur analogique.

**9.** Dispositif de conversion d'énergie mécanique vibratoire en énergie électrique selon l'une quelconque des revendications 2 à 8, dans lequel les premier et deuxième systèmes de condensateurs (C1, C2) sont dimensionnés de sorte que le circuit de commande (81, 82) puisse faire varier la capacité équivalente Ce des première et deuxième branches en parallèle entre une valeur inférieure à 0,2*Cp et une valeur supérieure à 1,5*Cp, avec Cp la capacité du système piézoélectrique (110, 120).

**10.** Dispositif de conversion d'énergie mécanique vibratoire en énergie électrique selon l'une quelconque des revendications 2 à 9, comprenant en outre : une source de tension continue (12) à amplitude ajustable connectée en série avec le convertisseur (11), le circuit de commande étant configuré pour modifier l'amplitude de la source de tension continue.

**11.** Dispositif de conversion d'énergie mécanique vibratoire en énergie électrique selon la revendication 1, dans lequel le convertisseur (11) inclut au moins un électret et deux électrodes collectrices, l'électret étant déplacé par rapport à une des électrodes collectrices lors de l'application de vibrations.

**12.** Dispositif de conversion d'énergie mécanique vibratoire en énergie électrique selon l'une quelconque des revendications précédentes, dans lequel les premier et deuxième systèmes de condensateurs comprennent un ensemble de condensateurs (C11-C1 n, C21-C2n), chacun des condensateurs de cet ensemble étant connecté en série avec un interrupteur respectif commandé par le circuit de commande.

**13.** Dispositif de conversion d'énergie mécanique vibratoire en énergie électrique selon la revendication 12, dans lequel :

- la première branche comprend un ensemble de n condensateurs C1i connectés en parallèle, i étant un entier compris entre 1 et n, chaque condensateur C1i étant connecté en série avec un interrupteur respectif k1i, les capacités des condensateurs C1 i étant définies par la relation $C1i=2^{i-1}*C\alpha$, avec $C\alpha$ une valeur de capacité de référence ;
- la deuxième branche comprend un ensemble de n condensateurs C2i connectés en parallèle, i étant un entier compris entre 1 et n, chaque condensateur C2i étant connecté en série avec un interrupteur respectif k2i, les capacités des condensateurs C2i étant définies par la relation $C2i=2^{i-1}*C\beta$, avec $C\beta$ une valeur de capacité de référence.

**14.** Dispositif de conversion d'énergie mécanique vibratoire en énergie électrique selon la revendication 12 ou 13, comprenant un compteur numérique dont chaque bit de sortie commande un interrupteur respectif.

**15.** Dispositif de conversion d'énergie mécanique vibratoire en énergie électrique selon l'une quelconque des revendications précédentes, dans lequel le circuit de commande comprend un circuit de régulation configuré pour modifier les capacités des premier et deuxième systèmes de condensateurs de façon à optimiser la puissance dans la charge (4) du circuit électrique (9).

**16.** Dispositif de conversion d'énergie mécanique vibratoire en énergie électrique selon l'une quelconque des revendications précédentes, dans lequel la différence de potentiel maximale générée par le convertisseur (11) est au moins cinq fois supérieure à la différence de potentiel d'alimentation du circuit à alimenter (4).

**Patentansprüche**

**1.** Vorrichtung zur Umwandlung mechanischer Vibrationsenergie in elektrische Energie, die folgendes beinhaltet:

- einen Transformator (11), der, wenn er Vibrationen unterliegt, eine Potentialdifferenz erzeugt
- einen Stromkreis (9), der mit den Klemmen des Transformators verbunden ist und der erste und zweite Parallelanschlüsse aufweist, der erste Anschluss aufweist ein erstes Kondensatorssystem mit variabler Kapazität (C1) und der zweite Anschluss aufweist eine zu speisenden elektrische Ladung (4);
**Gekennzeichnet dadurch, dass**:

- der zweite Anschluss aufweist ein zweites Kondensatorsystem mit variabler Kapazität (C2) in Reihenschaltung mit der elektrischen Ladung (4);

- eine Steuerleitung (81,82), die so konfiguriert ist, dass sie die entsprechenden Kapazitäten der ersten und zweiten Kondensatorsysteme so verändert, dass die mechanische Resonanzfrequenz des Transformators verändert wird.

2. Vorrichtung zur Umwandlung mechanischer Vibrationsenergie in elektrische Energie gemäß Anspruch 1, bei der der Transformator (11) mindestens ein piezoelektrisches System (110,120) beinhaltet, das bei der Anwendung von Vibrationen verformt wird.

3. Vorrichtung zur Umwandlung mechanischer Vibrationsenergie in elektrische Energie gemäß Anspruch 2, bei der das piezoelektrische System auf einem Balken (100) befestigt ist, der ein erstes in einer vibrierenden Stütze (5) eingefügtes Ende und ein zweites in einer mobilen Masse (6) eingefügtes Ende aufweist.

4. Vorrichtung zur Umwandlung mechanischer Vibrationsenergie in elektrische Energie gemäß Anspruch 3, bei der das piezoelektrische System (110,120) in der Längsrichtung des Balkens (100) polarisiert ist.

5. Vorrichtung zur Umwandlung mechanischer Vibrationsenergie in elektrische Energie gemäß Anspruch 3 oder 4, die außerdem folgendes enthält:

   - einen Beschleunigungsmesser (830), der so konfiguriert ist, dass er die momentane Beschleunigung der vibrierenden Stütze (5) misst;
   - eine Vorrichtung zur Messung der momentanen Spannung der Klemmen des piezoelektrischen Systems;

   die Steuerleitung (8) ist so konfiguriert, dass sie die entsprechenden Kapazitäten der ersten und zweiten Kondensatorsysteme so verändert, dass die Spannung der Klemmen des piezoelektrischen Systems in Phasenumtastung mit der Beschleunigung der vibrierenden Stütze (5) aufrechterhalten wird.

6. Vorrichtung zur Umwandlung mechanischer Vibrationsenergie in elektrische Energie gemäß Anspruch 5, die einen ersten Spannungsvergleicher enthält, der ab der gemessenen momentanen Beschleunigung ein Rechtecksignal erzeugt und einen zweiten Spannungsvergleicher, der ein Rechtecksignal ab der gemessenen Spannung erzeugt, einen Phasenverschieber, der eine Verschiebung von 90° an einem der erzeugten Rechtecksignale anbringt, wobei die Steuerleitung (8) die entsprechenden Kapazitäten der ersten und zweiten Kondensatorsysteme entsprechend der relativen Phase zwischen dem ab dem einen Rechtecksignal erzeugten phasenverschobenen Signal und dem anderen Rechtecksignal modifiziert.

7. Vorrichtung zur Umwandlung mechanischer Vibrationsenergie in elektrische Energie gemäß Anspruch 5, die einen ersten Spannungsvergleicher enthält, der ein ab der gemessenen momentanen Beschleunigung ein Rechtecksignal erzeugt und einen zweiten Spannungsvergleicher, der ein Rechtecksignal ab der gemessenen Spannung erzeugt, einen Stromkreis (840), der die Einschaltdauer der Betreibung zwischen den erzeugten Rechtecksignalen bestimmt, wobei die Steuerleitung (8) die entsprechenden Kapazitäten der ersten und zweiten Kondensatorsysteme entsprechend der festgelegten Einschaltdauer der Betreibung modifiziert.

8. Vorrichtung zur Umwandlung mechanischer Vibrationsenergie in elektrische Energie gemäß Anspruch 5, die einen Analogmultiplizierer enthält, der die durch die gemessene Spannung gemessene Beschleunigung multipliziert, wobei die Steuerleitung (8) die entsprechenden Kapazitäten der ersten und zweiten Kondensatorsysteme entsprechend der Gleichstromkomponente des Ausgangssignals des analogen Multiplikators modifiziert.

9. Vorrichtung zur Umwandlung mechanischer Vibrationsenergie in elektrische Energie gemäß irgendeinem der Ansprüche 2 bis 8, bei der die ersten und zweiten Kondensatorsysteme (C1, C2) so dimensioniert sind, dass die Steuerleitung (81,82) die entsprechende Kapazität CE der ersten und zweiten Parallelanschlüsse zwischen einem Wert, der unterhalb 0,2* Cp liegt, und einem Wert, der über 1,5* Cp liegt, schwanken lassen kann, Cp bedeutet die Kapazität des piezoelektrischen Systems (110,120).

10. Vorrichtung zur Umwandlung mechanischer Vibrationsenergie in elektrische Energie gemäß irgendeinem der Ansprüche 2 bis 9, die außerdem folgendes enthält: eine durchgehende Spannungsquelle (12) mit einstellbarer Amplitude in Serienschaltung mit dem Transformator (11), wobei die Steuerleitung so konfiguriert ist, dass sie die Amplitude der durchgehenden Spannungsquelle modifiziert.

11. Vorrichtung zur Umwandlung mechanischer Vibrationsenergie in elektrische Energie gemäß Anspruch 1, bei der der Transformator (11) mindestens ein Elektret und zwei Kollektor-Elektroden einschließt, wobei das Elektret bei Anwendung von Vibrationen gegenüber einer der Kollektor-Elektroden verschoben ist.

**12.** Vorrichtung zur Umwandlung mechanischer Vibrationsenergie in elektrische Energie gemäß irgendeinem der vorgenanntenn Ansprüche, bei der die ersten und zweiten Kondensatorsysteme eine Kondensatoreinheit (C11-C1n, C12-C2n) enthalten, wobei jeder der Kondensatoren dieser Einheit in Reihenschaltung mit einem entsprechenden Schalter verbunden ist, der durch die Steuerleitung gesteuert wird.

**13.** Vorrichtung zur Umwandlung mechanischer Vibrationsenergie in elektrische Energie gemäß Anspruch 12, bei der:

- der erste Anschluß enthält eine Einheit von n parallel geschaltete Kondensatoren C1i, wobei i ein zwischen 1 und n enthaltenes Ganzes darstellt und jeder Kondensator C1i in Reihenschaltung mit einem entsprechenden Schalter k1i verbunden ist und die Kapazitäten der Kondensatoren C1i sind durch das Verhältnis $C1i=2^i-1 \, {}^*C\alpha$ bestimmt, mit $C\alpha$ einem Referenz-Kapazitätswert;
- der zweite Anschluß enthält eine Einheit von n parallel geschaltete Kondensatoren C2i, wobei i ein zwischen 1 und n enthaltenes Ganzes darstellt und jeder Kondensator C2i mit einem entsprechenden Schalter k2i in Reihenschaltung verbunden ist und die Kapazitäten der Kondensatoren C2i sind durch das Verhältnis $C2^i=2 \, {}^*C\text{ß}$ bestimmt, mit $C\text{ß}$ einem Referenz-Kapazitätswert.

**14.** Vorrichtung zur Umwandlung mechanischer Vibrationsenergie in elektrische Energie gemäß den Ansprüchen 12 oder 13, die einen digitalen Zähler enthält, von dem jedes Ausgangsbit einen entsprechenden Schalter steuert.

**15.** Vorrichtung zur Umwandlung mechanischer Vibrationsenergie in elektrische Energie gemäß irgendeinem der vorgenannten Ansprüche, bei der die Steuerleitung einen Steuerkreis enthält, der so konfiguriert ist, dass er die Kapazitäten der ersten und zweiten Kondensatorsysteme so modifiziert, dass die Leistung in der Ladung (4) des Stromkreises (9) optimiert wird.

**16.** Vorrichtung zur Umwandlung mechanischer Vibrationsenergie in elektrische Energie gemäß irgendeinem der vorgenannten Ansprüche, bei der die durch den Transformator (11) erzeugte maximale Potentialdifferenz mindestens fünf mal höher ist als die Potentialdifferenz der Versorgung des zu speisenden Stromkreises (4).

## Claims

**1.** Device for converting mechanical vibrational energy into electrical energy (1), comprising:

- a converter (11) generating a potential difference when subjected to vibrations;
- an electrical circuit (9) connected to the terminals of the converter comprising first and second parallel branches, the first branch comprising a first condenser system with variable capacity (C1), the second branch comprising an electrical load (4) to feed;
**Characterised in that**:
- the second branch includes a second condenser system with variable capacity (C2) in series with the electrical load (4);
- a control circuit (81, 82) configured to modify the respective capacities of the first and second condenser systems so as to modify the mechanical resonance of the converter.

**2.** Device for converting mechanical vibrational energy into electrical energy according to claim 1 in which the converter (11) includes at least one piezoelectrical system (110, 120) deformed when vibrations are applied.

**3.** Device for converting mechanical vibrational energy into electrical energy according to claim 2, in which the piezoelectrical system is fixed to a beam (100) having a first end recessed into a vibrating support (5) and a second end recessed into a mobile mass (6).

**4.** Device for converting mechanical vibrational energy into electrical energy according to claim 3, in which the piezoelectrical system (110, 120) is polarised in the direction of the length of the beam (100).

**5.** Device for converting mechanical vibrational energy into electrical energy according to claim 3 or 4, further comprising:

- an accelerometer (830) configured to measure the instantaneous acceleration of the vibrating support (5);

- a measuring device of the instantaneous voltage at the terminals of the piezoelectrical system;
- control circuit (8) being configured to modify the respective capacities of the first and second condenser systems so as to maintain the voltage at the terminals of the piezoelectrical system in quadrature phase with the acceleration of the vibrating support (5).

6. Device for converting mechanical vibrational energy into electrical energy according to claim 5, comprising a first comparator circuit generating a square signal from the instantaneous measured acceleration and a second comparator circuit generating a square signal from the measured voltage, a phase shift circuit applying a phase shift of 90° to one of the generated square signals, the control circuit (8) modifying the respective capacities of the first and second condenser systems depending on the relative phase between the phase shifted signal generated from a square signal and the other square signal.

7. Device for converting mechanical vibrational energy into electrical energy according to claim 5, comprising a first comparator circuit generating a square signal from the measured instantaneous acceleration and a second comparator circuit generating a square signal from the measured voltage, a circuit (840) determining the duty recovery ratio between the generated square signals, the control circuit (8) modifying the respective capacities of the first and second condenser systems depending on the determined duty recovery ratio.

8. Device for converting mechanical vibrational energy into electrical energy according to claim 5, comprising an analogue multiplier multiplying the acceleration measured by the measured voltage, the control circuit (8) modifying the respective capacities of the first and second condenser systems depending on the DC component of the output signal of the analogue multiplier.

9. Device for converting mechanical vibrational energy into electrical energy according to anyone of the claims 2 to 8 in which the first and second condenser systems (C1, C2) are sized so that the control circuit (81, 82) can vary the equivalent capacity Ce of the first and second branches in parallel between a value less than 0,2*Cp and a value greater than 1,5 *Cp where Cp is the capacity of the piezoelectrical system (110, 120).

10. Device for converting mechanical vibrational energy into electrical energy according to anyone of the claims 2 to 9 further comprising: a DC voltage source (12) of adjustable amplitude connected in series to the converter (11), the control circuit being configured to modify the amplitude of the DC voltage.

11. Device for converting mechanical vibrational energy into electrical energy according to claim 1 in which the converter (11) includes at least an electret and two collecting electrodes, the electret being displaced relative to one of the collecting electrodes when vibrations are applied.

12. Device for converting mechanical vibrational energy into electrical energy according to any one of the preceding claims in which the first and second condenser systems comprise a set of condensers (C11-C1 n, C21-C2n), each of the condensers of this set being connected in series to a respective switch controlled by the control circuit.

13. Device for converting mechanical vibrational energy into electrical energy according to claim 12 in which:

- the first branch comprises a set of n condensers C1i connected in parallel, i being an integer between 1 and n, each condenser C1i being connected in series to a respective switch K1i, the condenser capacities C1i being defined by the relationship $C1^i = 2^{i-1} *C\alpha$ with $C\alpha$ being a reference capacity value;
- the second branch comprises a set of n condensers C2i connected in parallel, i being an integer between 1 and n, each condenser C2i being connected in series to a respective switch k2i, the condenser capacities C2i being defined by the relationship $C2^i = 2^{i-1} *C\text{ß}$ with Cß being a reference capacity value.

14. Device for converting mechanical vibrational energy into electrical energy according to claim 12 or 13 comprising a digital counter in which each output bit controls a respective switch.

15. Device for converting mechanical vibrational energy into electrical energy according to anyone of the preceding claims in which the control circuit comprises a control circuit configured to modify the capacities of the first and second condenser systems so as to optimise the power in the load (4) of the electrical circuit (9).

16. Device for converting mechanical vibrational energy into electrical energy according to anyone of the preceding claims in which the maximum potential difference generated by the converter (11) is at least five times greater than

**EP 2 668 716 B1**

the difference of potential power supply of the circuit (4) to feed.

**17**

Fig. 1

Fig. 2

Fig. 3

Fig. 4

Fig. 5

Fig. 6

Fig. 7

Fig. 8

Fig. 9

## Fig. 10

## Fig. 11

## Fig. 12

Fig. 13

Fig. 14

## Fig. 15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- *Tunable Capacitor Based on Polymer-Dispersed Liquid Crystal for Power Harvesting Microsystems,* 01 Octobre 2008

- **MS GOLDSCHMIDTBOING ; MULLER.** Optimization of resonant harvesters in piezopolymercomposite technology. *PowerMEMS,* 28 Novembre 2007